Europäisches Patentamt

European Patent Office

Office européen des brevets

(11) Veröffentlichungsnummer: **0 140 820**
A2

(12) # EUROPÄISCHE PATENTANMELDUNG

(21) Anmeldenummer: **84730088.6**

(22) Anmeldetag: **17.08.84**

(51) Int. Cl.⁴: **H 01 S 3/08,** H 01 S 3/086, H 01 S 3/02

(30) Priorität: **19.08.83 DE 3330434**

(43) Veröffentlichungstag der Anmeldung: **08.05.85** Patentblatt 85/19

(84) Benannte Vertragsstaaten: **AT BE CH DE FR GB IT LI LU NL SE**

(71) Anmelder: **Heinrich-Hertz-Institut für Nachrichtentechnik Berlin GmbH, Einsteinufer 37, D-1000 Berlin 10 (DE)**

(72) Erfinder: **Grosskopf, Gerd, Dr.-Ing., Spirdingseestrasse 46, D-1000 Berlin 49 (DE)**
Erfinder: **Küller, Lothar, Ing.-grad., Mauschbacher Steig 16, D-1000 Berlin 26 (DE)**
Erfinder: **Peters, Klaus, Ing.-grad., Westendallee 98c, D-1000 Berlin 26 (DE)**
Erfinder: **Wenke, Gerhard, Dipl.-Phys., Sächsische Strasse 63 a, D-1000 Berlin 31 (DE)**

(74) Vertreter: **Wolff, Konrad, Heinrich-Hertz-Institut für Nachrichtentechnik Berlin GmbH Einsteinufer 37, D-1000 Berlin 10 (DE)**

(54) **Stabilisationseinrichtung für einen Halbleiter-Laser.**

(57) In der optischen Nachrichtentechnik gewinnen Monomode-Systeme zunehmend an Bedeutung. Allerdings sind dort auf das Zusammenspiel von Laserspektrum und Dispersion des Lichtwellenleiters unangenehme Effekte zurückzuführen, gegen die aber mit einem externen Reflektor wirksam vorgegangen werden kann.

Die Stabilisationseinrichtung gemäss der Erfindung für einen monomodalen optischen Sender kann am Wärmesenke-block (5) eines handelsüblichen Lasers (3) befestigt werden und gestattet, zur Justierung des Hohlspiegels (2) zunächst den Federklemmenkörper (4) gegenüber dem Wärmesenke-block (5) in der zur axialen Richtung senkrechten Ebene zu verschieben. Danach wird der Abstand Laser (3) / Hohlspiegel (2) durch eine axiale Verschiebung des Spiegelkörpers (1) eingestellt. Für eine entsprechende Halterung des Spiegelkörpers (1) ist eine Klemme (11) vorgesehen. Der Spiegelkörper (1) kann an seinem Ende mit dem Hohlspiegel (2) einen abgeflachten Vorsprung (8) haben, einen verdrehsicheren Querschnitt oder bei kreisförmigem Querschnitt einen Stift (6) als Verdrehsiche-rung aufweisen.

HEINRICH-HERTZ-INSTITUT FÜR NACHRICHTENTECHNIK BERLIN
GMBH                                              11/0883 EP

Stabilisationseinrichtung für einen Halbleiter-Laser

Die Erfindung bezieht sich auf eine Stabilisationseinrichtung für einen Halbleiter-Laser mit einem externen Reflektor an der Rückseite des Lasers.

In der optischen Nachrichtentechnik gewinnen Monomode-Systeme zunehmend an Bedeutung. Zu den dabei zu lösenden Problemen, die bei Multimode-Systemen von noch größeren Störungen überdeckt wurden, gehören die unangenehmen Effekte, die auf das Zusammenspiel von Laserspektrum und Dispersion des Lichtwellenleiters zurückzuführen sind. Ein wirksames Mittel gegen solche Effekte ist der Einsatz von externen Reflektoren.

Über derartige Maßnahmen wird z.B. in "Electronics Letters" vom 26. Nov. 1981 - Bd. 17, Nr. 24, Seiten 931 und 932 - und vom 9. Dez. 1982 - Bd. 18, Nr. 26, Seiten 1092 bis 1094 - berichtet. Nach den dort geschilderten Erfahrungen soll die Position des externen Reflektors so nachgeregelt werden, daß der Laser im Monomodebetrieb arbeitet. Als Meßgröße hierfür dient die Ausgangsleistung des Lasers, die im Monomodebetrieb ein Maximum erreicht. Hierzu wurde insbesondere eine durch thermische Längenänderung wirkende Verstell-Einrichtung und ein dazugehöriger Regelkreis entwickelt.

Die Erfindung zielt darauf ab, eine einfach und preisgünstig herzustellende, leicht handhabbare und störunanfällige Konstruktion für eine solche Stabilisationseinrichtung, insbesondere zur Verwendung bei einem stabilen, monomodalen optischen Sender zu schaffen. Dies wird gemäß der Erfindung erreicht durch
- einen in axialer Richtung verschiebbar gehalterten Spiegelkörper mit einem Hohlspiegel an seiner dem Laser zugewandten Stirnfläche, als Reflektor, und
- einen Federklemmenkörper als Halterung für den Spiegelkörper, der in der zur axialen Richtung senkrechten Ebene verschiebbar an dem den Laser tragenden Wärmesenkeblock befestigt ist.

Wesentlich für die Erfindung ist, daß nach einer anfänglichen Justierung des Reflektors während des Betriebs keine laufende Verstellung erforderlich ist, also automatisch verstellbare Elemente und Organe sowie Detektoren und Schaltungen für entsprechende Regelkreise entfallen können. Die Justierung des Reflektors
- Zentrierung durch Verschiebung des Federklemmenkörpers in der Ebene senkrecht zur axialen Richtung, Abstand in axialer Richtung durch Verschiebung des Spiegelkörpers in seiner Halterung mit axialer Führung - erfolgt durch Beobachtung (Mikroskop) von Objekt, d.h. lichtaussendendem Fleck des Lasers, und reflektiertem Bild, die zur Deckung gebracht werden. Damit wird das Optimum bezüglich der reflektierten Lichtleistung eingestellt. Ergibt sich nach dieser Justierung des Reflektors, daß der Laser zwischen zwei benachbarten Moden springen könnte, wird sein Spektrum durch Veränderung der Temperatur des Lasers etwas verschoben. Eine Temperaturregelung für den Laser ist ohnehin vorhanden, so daß damit kein zusätzlicher Aufwand verbunden ist. Der Temperaturbereich für die stabile Emission nur einer Mode beträgt z.B. bei einem Laser der Firma Hitachi - HLP 5400 - etwa $\pm 0,6^{\circ}$ C. Die Einstellung des stabi-

len Monomodebetriebs ist damit relativ unkritisch.

Bei bevorzugten Ausführungsformen der Erfindung ist der Spiegelkörper zylindrisch. Körper mit drei- oder mehreckigem Querschnitt sind nicht so leicht herzustellen, benötigen hingegen auch keine besondere Verdrehsicherung, für die bei der genannten Ausführungsform zweckmäßig ein am Spiegelkörper befestigtes, im Federklemmenkörper geführtes Element vorzusehen ist.

Besonders vorteilhafte Ausführungsformen der Erfindung weisen einen zylindrischen Zapfen am Spiegelkörper auf, in dessen dem Laser zugewandter Stirnfläche der Hohlspiegel eingeprägt ist. Die räumlichen Abmessungen in der unmittelbaren Nähe des Lasers sind derart gering, daß jede Möglichkeit zur Miniaturisierung genutzt werden muß. Dabei soll andererseits die Handhabbarkeit nicht außer Acht gelassen werden. Während der Spiegelkörper als solcher also nicht zu klein sein sollte, kann der Zapfen im räumlich kritischen Bereich der Stabilisierungseinrichtung sehr dünn ausgebildet sein. Dies ist auch fertigungstechnisch ohne große Schwierigkeiten machbar. Das Einprägen des Hohlspiegels in die Stirnfläche ist als Arbeitsvorgang an sich bekannt. Bei den erfindungsgemäßen Ausführungsformen liegt der Vorteil dabei jedoch darin, daß für den Hohlspiegel kein spezielles Bauelement aus einem besonderen Material verwendet wird, das dann oder vorher am Spiegelkörper befestigt werden müßte. Der gesamte Spiegelkörper kann bei Ausführungsformen der Erfindung aus einem einzigen Stück gebildet werden, einschließlich Hohlspiegel sowie gegebenenfalls dem zylindrischen Zapfen.

Weiterhin ist für Ausführungsformen der Erfindung die Form des Hohlspiegels wichtig. Dazu ist zu berücksichtigen, daß der Laser sein Licht in einer Keule mit einem Spitzenwinkel von etwa 30$^O$ abstrahlt. Da die abstrahlende Fläche des Lasers nicht kreisförmig ist, ist auch die Keule nicht rotationssymmetrisch. Dennoch hat sich gezeigt, daß eine rotationssymmetrische Spiegelfläche durchaus ausreicht. Vorteilhafte Ausführungsformen der Erfindung besitzen einen kugeligen Hohlspiegel. Hierfür ist als Stempel zum Eindrücken des Hohlspiegels auch nur eine Kugel und kein kompliziertes Gebilde erforderlich.

In diesem Zusammenhang soll auch noch kurz auf die Frage eingegangen werden, welche Größe der Hohlspiegel haben sollte. Je kleiner der Krümmungsradius ist, desto geringer ist naturgesetzmäßig der Abstand zwischen Laser und Reflektor. Ein geringer, derartiger Abstand ist bezüglich der gewünschten Wirkung wohl nicht schlecht. Hierfür werden beim eingangs erwähnten bekannten Stand der Technik Werte von 60 $\mu$m und 200 $\mu$m genannt. Aus konstruktionstechnischen Gründen sind zu kleine Abstände und Krümmungsradien nicht beliebt. Bei Ausführungsformen der Erfindung haben sich 500 $\mu$m als durchaus ausreichend herausgestellt.

Wahrscheinlich kommt es auch gar nicht so sehr darauf an, daß möglichst viel Licht in die hintere Abstrahlfläche des Lasers zurückgelangt. An die Qualität des Spiegels brauchen also wohl keine extremen Anforderungen gestellt zu werden. Darüber hinaus bzw. mit derselben Tendenz hat sich gezeigt, daß der Reflektor nicht unbedingt von einem vollständigen Hohlspiegel gebildet werden muß, d.h., auch ein Hohlspiegelsegment ausreicht. Es braucht also nicht das gesamte abgestrahlte Licht aufgefangen und möglichst vollständig reflektiert zu werden.

Dies schlägt sich in einer weiteren vorteilhaften Ausführungsform in folgender Weise nieder: an seiner Unterseite ist ein Vorsprung abgeflacht, und an seiner Stirnfläche befindet sich ein Segment eines Hohlspiegels. Der Vorsprung kann einen Teil oder auch die gesamte Länge des Zapfens o. dgl. einnehmen. Seine Abflachung an der Unterseite ermöglicht, auch bei größeren Krümmungsradien den erforderlichen Abstand zwischen Laser und Reflektor zu erzielen. Häufig sind nämlich handelsübliche Laser auf einem Submount oder auf einem Wärmesenkeblock montiert, bei denen die Abmessungen es sonst nicht erlauben würden, einen Reflektor mit einem nicht allzu großen Krümmungsradius im erforderlichen Abstand anzubringen.

Bei Ausführungsformen der Erfindung können an der Rückseite des Spiegelkörpers mechanisch zu betätigende Verstellelemente vorgesehen sein. Diese dienen dazu, die axiale Verschiebung bei der Justierung des Spiegelkörpers herbeizuführen. Dazu sollte beispielsweise ein Gewindesackloch vorhanden sein.

Die Ausbildung des Federklemmenkörpers bei Ausführungsformen der Erfindung erfolgt vorteilhaft aus einem Material, das zumindest ähnliche thermische Eigenschaften aufweist wie das Material des Wärmesenkeblocks. Temperaturänderungen und damit verbundenen Dehnungen sollen beide Blöcke in etwa gleichem Umfang unterliegen, um Spannungen und eine Dejustierung des Spiegelkörpers zu vermeiden. Derartiges Material weist im allgemeinen auch die erforderlichen mechanischen Eigenschaften auf, die für die Federspannung der Halteklemme benötigt werden. Anderenfall können auch Lappen an den Federzungen und eine Spannschraube oder dgl. vorgesehen werden.

Sinnvoll und zweckmäßig ist schließlich noch, bei Ausführungsformen der Erfindung einen Federklemmenkörper mit einem verbreiterten Fuß auszubilden, durch den ein größerer Abstand zwischen Halteklemme des Spiegelkörpers und dem den Laser tragenden Wärmesenkeblock bzw. Submount gebildet wird. Dies erleichtert die Handhabung und Beobachtung bei der Justage des Spiegelkörpers.

In der Zeichnung sind Einzelheiten, die für die Erfindung und zum Verständnis der Funktion ihrer Ausführungsformen von Bedeutung sind, schematisch dargestellt. Dabei zeigen:

Fig. 1: in perspektivischer Darstellung den konstruktiven Aufbau eines Halbleiterlaser-Senders mit Stabilisationseinrichtung;

Fig. 2: eine Prinzipskizze für einen Laser mit angekoppeltem Lichtwellenleiter an der Vorder- und einem Reflektor an der Rückfront;

Fig. 3: ein typisches Laserspektrum, das sich bei einem isolierten Laser ausbildet;

Fig. 4: drei Laserspektren bei Laser-Faser-Ankopplung ohne rückwärtigen Reflektor für drei verschiedene Laser-Faser-Abstände, zum direkten Vergleich mit Fig. 3

0140820

- 7 -

sind alle vier Spektrenbilder auf eine
Sollwellenlänge bezogen untereinander
dargestellt,
und Fig. 5: ein Laserspektrum für eine Anordnung
gemäß Fig. 1 und 2, in logarithmischer
Darstellung.

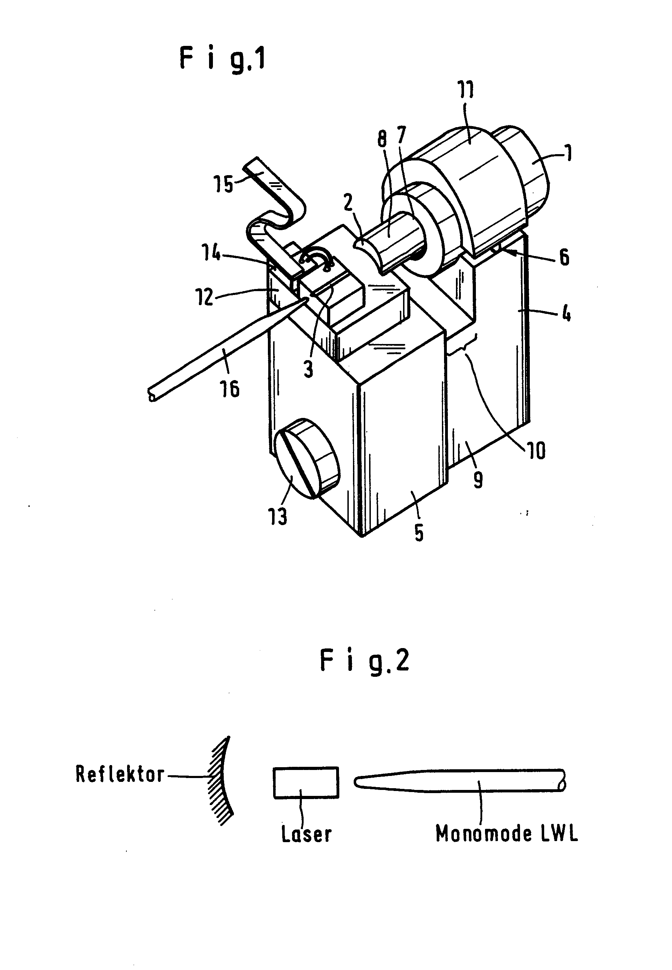

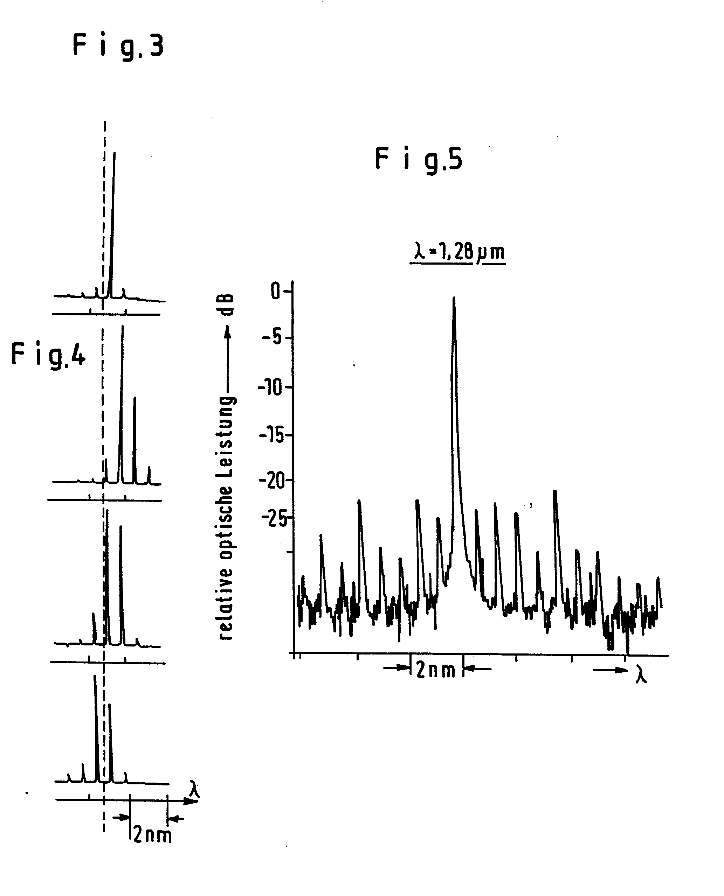

Bei dem in Fig. 1 dargestellten konstruktiven Aufbau
für einen stabilen, monomodalen optischen Sender kann
ein handelsüblicher Laser 3 verwendet werden. Dabei
ist der Laser 3 gegebenenfalls auf einem Submount 12,
auf jeden Fall auf einem Wärmesenkeblock 5 befestigt.
Für die Stromzuführung zum Laser 3 ist ebenfalls bereits an einem Isolator 14 ein federndes Element 15,
z.B. ein Goldband, vorgesehen. Eine Koppeleinrichtung,
mit der ein Lichtwellenleiter 16 mit einem Taper auf
die vordere Abstrahlfläche des Lasers 3 justierbar ist,
ist aus Gründen der besseren Übersichtlichkeit bei dieser Darstellung weggelassen worden. Derartige Einrichtungen sind ebenfalls erhältlich, und da sich die Erfindung hiermit nicht näher befaßt, kann auch aus diesem
Grunde auf eine Darstellung und nähere Erläuterung verzichtet werden.

Die Stabilisationseinrichtung für den Laser 3 enthält
einen Spiegelkörper 1, dessen Hohlspiegel 2 an der
Rückseite des Lasers 3 auf dessen dort abstrahlende
Fläche genau justierbar sein muß. Wie bei der dargestellten Ausführungsform wird bei der Erfindung dabei
davon ausgegangen, daß von den in den drei Raumkoordinaten erforderlichen Verschiebungen zunächst eine Einstellung des reflektierten Laser-Bildes derart erfolgen muß, daß dieses auf die Längsachse des Lasers 3 fällt. Dann ist der Abstand Laser 3/Hohlspiegel 2 durch eine Verschiebung des Spiegelkörpers 1 in dieser Längsachse einzustellen. Verschiebungen in der zur axialen Richtung senkrechten Ebene lassen sich durchführen, indem ein Schraubenbolzen 13, der durch den Wärmesenkeblock 5 in einer Durchgangsbohrung mit reichlichem Spiel geführt wird und in einem Gewindesackloch des Federklemmenkörpers 4 sitzt, etwas gelockert wird und der Federklemmenkörper 4 gegenüber dem Wärmesenkeblock 5 hin und her bewegt wird. Fällt das reflektierte Bild des Lasers 3 auf die Längsachse, wird der Schraubenbolzen 13 fest angezogen. Nunmehr erfolgt die Längsverschiebung des Spiegelkörpers 1, z.B. mit - nicht dargestellten - Verstellelementen an der Rückseite des Spiegelkörpers 1. Ist der Spiegelkörper 1 zylindrisch ausgebildet, sollte zur Verdrehsicherung ein Stift 6 vorgesehen werden, der fest in radialer Richtung im Spiegelkörper 1 sitzt und z.B. im Federspalt der eigentlichen Halteklemme 11 für den Spiegelkörper 1 nur Längsbewegungen zuläßt.

Dies ist von besonderer Bedeutung für Ausführungsformen der Erfindung, bei denen ein zum Hohlspiegel 2 führender Zapfen 7 unsymmetrisch, insbesondere mit einem abgeflachten Vorsprung 8 ausgebildet ist. Die Abflachung dient zur Verminderung der Raumnot in diesem Bereich der Stabilisationseinrichtung und soll sich exakt auf der Unterseite des Vorsprungs 8 befinden. Der Hohlspiegel 2 besteht dann zwar nur aus einem Segment einer sphärischen Fläche, die aber unter diesen Umständen mit einem größeren Krümmungsradius ausgebildet sein kann. Auch unter dem Aspekt der Raumnot in diesem Bereich kann der Federklemmenkörper 4 mit einem verbreiterten Fuß 9 ausgebildet sein, um einen größeren Abstand 10 zwischen der Halteklemme 11 und dem Wärmesenkeblock 5 bzw. dem Submount 12 zu schaffen.

Federklemmenkörper 4 und Wärmesenkeblock 5 sind übrigens thermisch nicht voneinander isoliert. Sie sollten zudem aus Material bestehen, das zumindest ähnliche thermische Eigenschaften aufweist, d.h. Wärmebewegungen in etwa gleichem Umfang ausführen, um die Justierungsverhältnisse zu erhalten.

In Fig. 2 sind die drei Komponenten für einen stabilen monomodalen optischen Sender: Laser, Monomode LWL und Reflektor schematisch angegeben.

Der Reflektor bewirkt eine wesentliche Verbesserung des monomodalen Verhaltens des Lasers. Bei einem Laser ohne Reflektor führt selbst eine auf geringe Störungen des Laserspektrums optimierte Faserankopplung zu einer Beeinflussung des Laserspektrums. Sobald der oben genannte Reflektor zum Einsatz kommt, wird das monomodale Verhalten des Lasers von der Faserankopplung jedoch nicht mehr beeinträchtigt.

Zur Veranschaulichung des Ausmaßes dieser einzelnen Einflüsse ist in Fig. 3 ein, durch Wahl des Arbeitspunktes gutes Spektrum eines isolierten Lasers, also sowohl ohne angekoppelten Lichtwellenleiter als auch ohne Reflektor, dargestellt. Neben einer einzigen, ausgeprägten Spektrallinie sind in dessen Nachbarschaft nur wenige, sehr viel geringer ausgeprägte Spektrallinien festzustellen.

Die Fig. 4 zeigt für drei verschiedene Abstände Laser/ LWL in jedem Fall zwei stark ausgeprägte und daneben weitere, etwas schwächere Spektrallinien. Außerdem ist die Ausprägung der Spektrallinien, bezogen auf eine Sollwellenlänge, mehr oder weniger weit in der einen oder der anderen Richtung verschoben.

In Fig. 5 schließlich ist das Spektrum eines Lasers mit externer Stabilisierung durch einen Reflektor, übrigens in logarithmischer Darstellung, angegeben. Alles, was dort neben der einen ausgeprägten Spektrallinie erscheint, liegt, bezogen auf diese, unter 1 %! Im Vergleich zum Spektrum gemäß Fig. 3 ist also sogar eine Verbesserung um etwa den Faktor 10 erreicht worden.

HEINRICH-HERTZ-INSTITUT FÜR NACHRICHTENTECHNIK BERLIN
GmbH                                                    11/0883 EP


Patent-Ansprüche

1. Stabilisationseinrichtung für einen Halbleiter-Laser
mit einem externen Reflektor an der Rückseite des Lasers,
g e k e n n z e i c h n e t   d u r c h
- einen in axialer Richtung verschiebbar gehalterten
   Spiegelkörper (1) mit einem Hohlspiegel (2) an seiner
   dem Laser (3) zugewandten Stirnfläche, als Reflektor
und
- einen Federklemmenkörper (4) als Halterung für den
   Spiegelkörper (1), der in der zur axialen Richtung
   senkrechten Ebene verschiebbar an dem den Laser (3)
   tragenden Wärmesenkeblock (5) befestigt ist.


2. Stabilisationseinrichtung nach Anspruch 1,
g e k e n n z e i c h n e t   d u r c h
einen zylindrischen Spiegelkörper (1).


3. Stabilisationseinrichtung nach Anspruch 2,
g e k e n n z e i c h n e t   d u r c h
ein am Spiegelkörper (1) befestigtes, im Federklemmenkörper (4) geführtes Element (6) zur Verdrehsicherung
des Spiegelkörpers (1).


4. Stabilisationseinrichtung nach einem der Ansprüche
1 bis 3,
g e k e n n z e i c h n e t   d u r c h
einen zylindrischen Zapfen (7) am Spiegelkörper (1),
in dessen dem Laser (3) zugewandter Stirnfläche der
Hohlspiegel (2) eingeprägt ist.

5. Stabilisationseinrichtung nach einem der Ansprüche 1 bis 4,

g e k e n n z e i c h n e t   d u r c h

einen kugeligen Hohlspiegel (2).

6. Stabilisationseinrichtung nach einem der Ansprüche 1 bis 5,

g e k e n n z e i c h n e t   d u r c h

einen an seiner Unterseite abgeflachten Vorsprung (8) mit einem Segment eines Hohlspiegels (2) an der Stirnfläche.

7. Stabilisationseinrichtung nach einem der Ansprüche 1 bis 6,

g e k e n n z e i c h n e t   d u r c h

mechanisch zu betätigende Verstellelemente an der Rückseite des Spiegelkörpers (1).

8. Stabilisationseinrichtung nach einem der Ansprüche 1 bis 7,

g e k e n n z e i c h n e t   d u r c h

einen Federklemmenkörper (4) aus einem Material, das zumindest ähnliche thermische Eigenschaften aufweist wie das Material des Wärmesenkeblocks (5).

9. Stabilisationseinrichtung nach einem der Ansprüche 1 bis 8,

g e k e n n z e i c h n e t   d u r c h

einen Federklemmenkörper (4) mit einem verbreiterten Fuß (9), durch den ein größerer Abstand (10) zwischen Halteklemme (11) für den Spiegelkörper (1) und dem den Laser (3) tragenden Wärmesenkeblock (5) bzw. Submount (12) gebildet wird.

Fig.1

Fig.2

Reflektor — Laser — Monomode LWL

Fig.3

Fig.5

λ = 1,28 μm

Fig.4

relative optische Leistung ⟶ dB

0
−5
−10
−15
−20
−25

├─ 2nm ─┤ ⟶ λ

├─ 2nm ─┤ λ